(19) **Europäisches Patentamt**

**European Patent Office**

**Office européen des brevets**

(11) Veröffentlichungsnummer: **0 255 012 B1**

(12) ## EUROPÄISCHE PATENTSCHRIFT

(45) Veröffentlichungstag der Patentschrift: **24.03.93**

(51) Int. Cl.⁵: **C23C 18/28**

(21) Anmeldenummer: **87110463.4**

(22) Anmeldetag: **20.07.87**

(54) **Verfahren zur Verbesserung der Haftfestigkeit von stromlos abgeschiedenen Metallschichten auf Kunststoffoberflächen.**

(30) Priorität: **29.07.86 DE 3625587**

(43) Veröffentlichungstag der Anmeldung:
**03.02.88 Patentblatt 88/05**

(45) Bekanntmachung des Hinweises auf die
Patenterteilung:
**24.03.93 Patentblatt 93/12**

(84) Benannte Vertragsstaaten:
**AT BE CH DE ES FR GB IT LI NL**

(56) Entgegenhaltungen:
**EP-A- 0 125 617      EP-A- 0 131 195
WO-A-88/02592      US-A- 3 560 257
US-A- 4 017 265      US-A- 4 469 714**

**Römpps Chemie-Lexikon, 8. Auflage (1985),
Franckh'sche Verlagshandlung, Stuttgart,
DE, Seiten 2559-2560**

(73) Patentinhaber: **BAYER AG**

**W-5090 Leverkusen 1 Bayerwerk(DE)**

(72) Erfinder: **Giesecke, Henning, Dr.
Walter-Flex-Strasse 29
W-5090 Leverkusen(DE)**
Erfinder: **Wolf, Gerhard Dieter, Dr.
Wilhelm-Busch-Strasse 29
W-4047 Dormagen(DE)**
Erfinder: **Probst, Joachim, Dr.
Humperdinckstrasse 42
W-5090 Leverkusen(DE)**
Erfinder: **Schuster, Klaus, Dipl.-Ing.
Gerhart-Hauptmann-Strasse 33
W-5090 Leverkusen 3(DE)**

EP 0 255 012 B1

**Beschreibung**

Es ist allgemein bekannt, daß man zum Zwecke der Erzielung haftfester Metallauflagen auf elektrisch nicht leitenden Trägerkörpern zunächst einen haftvermittelnden Lack auf der Basis von vorzugsweise ABS-Polymerisaten auf die Oberfläche aufträgt. Der Nachteil dieser Vorbehandlungsmethode besteht jedoch darin, daß der mit dieser Lackschicht überzogene Formkörper vor der eigentlichen Metallisierung zwecks Aufrauhung der Oberfläche mit einer Beize behandelt werden muß (vgl. z.B. DE-A 1 958 839).

Es ist deshalb bereits vorgeschlagen worden, nichtmetallische Substratoberflächen ohne vorheriges Beizen direkt mit Aktivatorlösungen für die stromlose Metallisierung zu behandeln, die als Haftvermittler komplizierte Gemische aus Acrylnitril/Butadien-Copolymerisaten und gegebenenfalls Phenolharzen enthalten (vgl. z.B. US 3 305 460 und 3 560 257).

Ein derartiges Verfahren konnte sich jedoch bisher in der Technik nicht durchsetzen, da die Haftfestigkeit der erzeugten Metallschichten nicht ausreichend ist und die haftvermittelnden Polymere die insbesondere in der Leiterplattentechnik geforderten hohen Anforderungen an die thermischen und elektrischen Eigenschaften nicht erfüllen.

Es wurde nun gefunden, daß man ohne die genannten Nachteile gut haftende Metallschichten auf elektrisch nicht leitenden Sustraten aufbringen kann, wenn man diese mit einer Aktivatorformulierung ohne Beizen behandelt, wobei die Schritte

(1) Aufbringung der bindemittelhaltigen Aktivatorformulierungen,

(2) Entfernung der Lösungsmittel falls vorhanden,

(3) Aktivierung durch Reduktion und

(4) stromlose Metallisierung

durchlaufen werden, die als Bindemittel ein Copolymerisat aus

a) 5 bis 80 Gew.-% eines cyangruppenhaltigen Monomeren aus der Gruppe von $\alpha$-Cyanacrylsäureester mit 1 bis 8 C-Atomen im Alkoholrest, Maleinsäuredinitril, Fumarsäuredinitril, Acrylnitril und $\alpha$-Alkylacrylnitrile,

b) 5 bis 40 Gew.-% gegebenenfalls kernsubstituiertes (Methyl)Styrol aus der Gruppe von Styrol, $\alpha$-Methylstyrol, o-Chlorstyrol, p-Chlorstyrol, o-, m- oder p-Methylstyrol, p-tert.-Butylstyrol und Methylmethacrylat oder deren Mischungen und/oder

c) 5 bis 40 Gew.-% (Meth)Acrylsäureester aus der Gruppe der Acrylsäurealkylester mit 1 bis 18 C-Atomen im Alkoholteil und Methacrylsäurealkylester mit 2 bis 18 C-Atomen im Alkoholteil oder deren Mischungen und/oder

d) 5 bis 40 Gew.-% ungesättigte Carbonsäure(derivate) aus der Gruppe der $\beta$-monoolefinisch ungesättigten Mono- oder Dicarbonsäuren mit 3 bis 5 C-Atomen und Maleinsäurehalbester mit 2 bis 18 C-Atomen im Alkoholteil oder deren Mischungen

enthält, das ein mittleres Molekulargewicht von 1.000 bis 1.000.000 aufweist.

Bevorzugte Copolymerisate enthalten 20 bis 50 Gew.-% der Komponente a).

Geeignete Komponenten a) sind $\alpha$-Cyanacrylsäureester mit 1 bis 8 C-Atomen im Alkoholrest, Maleinsäuredinitril, Fumarsäuredinitril und vor allem Acrylnitril und $\alpha$-Alkylacrylnitrile, wie Methacrylnitril.

Geeignete Komponenten b) sind:

Styrol, $\alpha$-Methylstyrol, o-Chlorstyrol, p-Chlorstyrol, o-, m- oder p-Methylstyrol, p-tert.-Butylstyrol oder Methylmethacrylat oder deren Mischungen.

Beispiele für Komponenten c) sind:

Acrylsäurealkylester mit 1 bis 18 C-Atomen im Alkoholrest oder Methacrylsäurealkylester mit 2 bis 18 C-Atomen im Alkoholrest oder deren Mischungen;

Beispiele für Komponenten d) sind:

$\beta$-monoolefinisch ungesättigte Mono- oder Dicarbonsäuren mit 3 bis 5 C-Atomen oder Maleinsäurehalbester mit 2 bis 18 C-Atomen im Alkoholrest oder deren Mischungen.

Die aufgeführten Alkoholreste können gegebenenfalls auch substituiert sein. Als Substituenten seien beispielsweise genannt: Halogene, insbesondere Fluor; Ethergruppen, Dialkylaminogruppen und Hydroxylgruppen.

Die erfindungsgemäß zu verwendenden Bindemittel haben ein mittleres Molekulargewicht von 1.000 bis 1.000.000, bevorzugt von 2.000 bis 100.000. Sie werden nach üblichen Polymerisationsverfahren hergestellt, wobei die Polymerisationstemperaturen zwischen 20 bis 200°C, bevorzugt zwischen 50 und 170°C liegen, und bei Drücken zwischen $10^3$ mbar und $2 \cdot 10^4$ mbar gearbeitet wird. Es hat sich als vorteilhaft erwiesen, die Copolymerisation in Lösung durchzuführen.

Als Aktivatoren kommen in den erfindungsgemäßen Formulierungen organische Metallverbindungen der 1. oder 8. Nebengruppen des Periodensystems (insbesondere Pd, Pt, Au und Ag) in Betracht, wie sie beispielsweise in den EP-A 34 485, 81 438, 131 195 beschrieben werden. Besonders geeignet sind organische Metallverbindungen des Palladiums mit Olefinen (Dienen), mit $\alpha$-, $\beta$-ungesättigten Carbonylverbindungen, mit Kronenethern und mit Nitrilen. Ganz besonders geeignet sind Butadienpalladiumdichlorid, Bisacetonitrilpalladiumdichlorid, 4-Cyclohexen-1,2-dicarbonsäureanhydridpalladiumdichlorid, Mesityloxidpalladiumchlorid, 3-Hepten-2-on-palladiumchlorid, 5-Methyl-3-hexen-2-on-palladiumchlorid.

Selbstverständlich können auch Gemische dieser Verbindungen eingesetzt werden. Die Konzentrationen an organischen Metall-Aktivatoren liegen in den erfindungsgemäßen Formulierungen zwischen 0,05 und 5 Gew.-%, bezogen auf das Edelmetall. In Sonderfällen können sie auch darunter oder darüber liegen. Sie können in den Formulierungen gelöst oder dispergiert vorliegen. Eine Lösung kann dabei auch durch Zusatz von Lösungsvermittlern hergestellt werden, z.B. von quaternären Ammoniumsalzen, wie Tetrabutylammoniumbromid. Bei einer Dispergierung der Aktivatoren ist dafür zu sorgen, daß Teilchengrößen unterhalb von 1 $\mu$m erreicht werden.

Besonders geeignet für das erfindungsgemäße Verfahren sind Formulierungen, die neben den Aktivatoren und den erfindungswesentlichen Bindemitteln Lösungsmittel, Füllstoffe sowie gegebenenfalls Tenside u.a. Hilfsmittel enthalten.

Als Lösungsmittel in den erfindungsgemäßen Formulierungen kommen in der Druck- bzw. Lackiertechnik bekannte Substanzen in Betracht wie aromatische und aliphatische Kohlenwasserstoffe, beispielsweise Toluol, Xylol, Benzin, Petrolether; Glyzerin; Ketone, beispielsweise Aceton, Methylethylketon, Cyclohexanon, Methylisobutylketon; Ester, beispielsweise Essigsäurebutylester, Phthalsäuredioctylester, Glykolsäurebutylester; Glykolether, beispielsweise Ethylenglykolmonomethylether, Diglyme, Propylenglykolmonomethylether; Ester von Glykolethern, beispielsweise Ethylglykolacetat, Propylenglykolmonomethyletheracetat; Diacetonalkohol. Selbstverständlich können auch Gemische dieser Lösungsmittel und ihre Verschnitte mit anderen Lösungsmitteln eingesetzt werden.

Als Füllstoffe kommen aus der Druck- bzw. Lackierungstechnik bekannte Hilfsstoffe wie Pigmente, disperse Kieselsäuren, Tonmineralien, Ruße und rheologische Additive in Betracht.

Als Beispiele seien genannt:

Aerosile, $TiO_2$, Talkum, Eisenoxide, Kieselgur, Schwerspate, Kaoline, Quarzmehl, Smectite, Farbruße, Graphite, Zinksulfide, Chromgelb, Bronzen, organische Pigmente und Kreide.

Die erfindungsgemäßen Formulierungen können zur Verbesserung ihrer Eigenschaften auch Verlaufsmittel (z.B. Silicone, Tenside) und Farbstoffe enthalten.

Die Herstellung der erfindungsgemäßen Formulierungen geschieht im allgemeinen durch Vermischen der Bestandteile. Dazu sind neben dem einfachen Rühren besonders die in der Lack- und Drucktechnik üblichen Naßverkleinerungsaggregate wie Kneter, Attritore, Walzenstühle, Dissolver, Rotor-Stator-Mühlen, Kugelmühlen sowie Rührwerkmühlen besonders geeignet. Selbstverständlich kann das Einarbeiten der Formulierungsbestandteile auch in getrennten Schritten durchgeführt werden. Beispielsweise kann man den Aktivator zuerst in den Bindern und Lösungsmitteln lösen bzw. dispergieren und dann erst die Füllstoffe einarbeiten. Auch ein vorheriges Anteigen der Füllstoffe in den Lösungsmitteln unter hohen Scherkräften ist eine mögliche Verfahrensvariante.

Durch Aufbringen der erfindungsgemäßen Formulierungen können Oberflächen zum Zweck einer haftfesten chemogalvanischen Metallisierung aktiviert werden. Das Aufbringen erfolgt im allgemeinen durch aus der Lack- bzw. Drucktechnik bekannte Verfahren.

Als Beispiele seien genannt:

Aufsprühen, Aufpinseln, Aufrollen, Offsetdruck, Siebdruck, Tampondruck, Tauchen.

Als elektrisch nicht leitende Substrate für das erfindungsgemäße Verfahren eignen sich Glas, Quarz, Keramik, Emaille, Papier, Polyethylen, Polypropylen, Epoxidharze, Polyester, Polycarbonate, Polyamide, Polyimide, Polyhydantoine, ABS-Kunststoffe, Silikone, Polyvinylhalogenide, Polyvinilidenfluorid in Form von Platten, Folien, Papieren und Vliesen. Besonders bevorzugt sind Substrate, wie sie in der Leiterplattenfertigung eingesetzt werden, z.B. Phenolharzpapiere, Glasfaser-verstärkte Epoxidplatten, Polyester-, Polyimidfolien und Keramik.

Nach dem Aufbringen der erfindungsgemäßen Formulierungen auf die Oberfläche werden die Lösungsmittel entfernt. Im allgemeinen geschieht dies durch Trocknen.

Das Trocknen kann bei unterschiedlichen Temperaturen, beispielsweise zwischen RT und 200 °C und unter Normaldruck oder auch im Vakuum erfolgen. Die Trocknungszeit kann selbstverständlich stark variiert werden. Häufig genügen kurze Zeiten.

Die so bekeimten Oberflächen müssen anschließend durch Reduktion aktiviert werden. Dazu können bevorzugt die in der Galvanotechnik üblichen Reduktionsmittel, wie z.B. Formaldehyd, Hypophosphit, Borane, Hydrazinhydrat verwendet werden. Natürlich sind auch andere Reduktionsmittel möglich.

Eine besonders bevorzugte Ausführungsform bei Verwendung der erfindungsgemäßen Formulierungen besteht darin, daß die Reduktion im Metallisierungsbad gleich mit dem Reduktionsmittel der stromlosen Metallisierung durchgeführt wird. Diese Ausführung ist besonders für aminboranhaltige Nickelbäder oder formalinhaltige Kupferbäder geeignet.

Die mit den erfindungsgemäßen Formulierungen aktivierten Oberflächen können in einem weiteren Verfahrensschritt stromlos metallisiert werden. Dafür kommen besonders Bäder mit Nickel-, Kobalt-, Eisen-, Kupfer-, Silber, Gold- und Palladiumsalzen oder deren Gemische in Betracht. Derartige Metallisierungsbäder sind in der Technik der stromlosen Metallisierung bekannt.

Die erfindungsgemäßen Formulierungen eignen sich besonders für eine partielle Aktivierung von Oberflächen, ganz besonders zur Herstellung von gedruckten Schaltungen, Folientastaturen, Schaltmatten und Sensoren nach üblichen Druckverfahren, wie z.B. Siebdruck, und anschließender additiven chemischen Metallisierung.

Beispiel 1

In einem 12 l VA-Autoklaven mit Ankerrührer und Temperaturregelung werden

| 2.600 Gew.-Teile | Propylenglykolmonomethyletheracetat (PMA) |
| --- | --- |

vorgelegt. Der Autoklav wird bei Raumtemperatur zur Entfernung von Sauerstoff auf ca. 20 mbar evakuiert, und sodann 3 mal mit 2 bar Stickstoff gespült. Sodann wird Stickstoff bis zu einem Überdruck von 0,5 bar aufgedrückt. Es wird eine Rührerdrehzahl von 100 U/min eingestellt und auf eine Innentemperatur von 120°C geheizt. Sodann werden über 2 Dosierpumpen innerhalb von 4 Stunden folgende Mischungen gleichmäßig zudosiert:

Monomerenmischung I:

```
  978 Gew.-Teile  Styrol
  978 "           Methylmethacrylat
  978 "           n-Butylacrylat
1.954 "           Acrylnitril.
```

Initiatorlösung II:

| 100 Gew.-Teile 580 Gew.-Teilen | tert.-Butylperoctoat gelöst in PMA. |
| --- | --- |

Nach beendeter Dosierzeit wird 30 Minuten bei 120°C nachgerührt und sodann eine zweite Initiatorlösung aus

| 16,8 Gew.-Teilen 84 Gew.-Teilen | Di-tert.-Butylperoxid gelöst in PMA |
| --- | --- |

zugedrückt. Zur Auspolymerisierung wird noch 4 Stunden bei 120°C nachgerührt. Nach Abkühlung auf 80°C wurde die hochviskose Lösung über das Bodenventil des Autoklaven abgelassen.
Ausbeute: 8.130 g Lösung
Die Konzentration der Lösung betrug 58,8 %, die Viskosität in 30 %iger Lösung in PMA 1.300 mPa.s bei 25°C.
Die Lösung bildet auf Glas und Polyesterfolien nach dem Austrocknen einen gut haftenden, leicht gelblichen transparenten Film.

Beispiel 2

```
260 Gew.-Teile einer Polymerlösung gemäß Beispiel 1
290 "              Ethylenglykolmonomethyletheracetat
120 "              Glykolsäurebutylester
 40 "              Aerosil      und
  6 "              Butadienpalladiumchlorid
```

werden in einem Dissolver vermischt. Die so erhaltene Paste wird durch ein Sieb auf eine PES-Folie gedruckt und der Druck 1 Stunde bei 100°C getrocknet. Anschließend wird der Druck 30 Minuten in einem aminboranhaltigen Nickelbad vernickelt. Man erhält eine zusammenhängende Nickelschicht.
Haftfestigkeit gemäß DIN 53 494: 14 N
Viskosität der Druckpaste: 3.600 mPa.s.

Beispiel 3

Mit einer Druckpaste gemäß Beispiel 2 wird ein Leiterbahnbild auf eine glasfaserverstärkte Epoxidharzplatte (FR-4-Material) gedruckt. Anschließend wird die Oberfläche bei 150°C 1 Stunde getrocknet und 1 Stunde in einem alkalischen formalinhaltigen Kupferbad (1,7 g/l Kupfer, 5 g/l NaOH, 8 g/l Formalin) bei 60°C verkupfert. Man erhält ein abbildungsgenaues Leiterbahnbild mit einer Kupferauflage von 3 $\mu$m.
Haftfestigkeit analog DIN 53 151: Kennwert GT 1.

Beispiel 4

480 Gew.-Teile einer Polymerlösung in Ethylenglykolethyletheracetat mit einem Feststoffgehalt von 30 % bestehend aus einem Copolymeren hergestellt gemäß Beispiel 1 aus

```
20 Gew.-Teilen Acrylnitril
20 "              Methacrylnitril
20 "              Methylmethacrylat
20 "              Styrol
20 "              n-Butylacrylat
20 "              eines Smectites (Bentone® 38)
 8 "              Bisacetonitrilpalladiumdichlorid
```

werden sorgfältig im Dissolver vermischt.
Die entstehende Mischung wird mit einem Rakel auf eine Tyvek-Papieroberfläche gestrichen, 2 Stunden bei 80°C getrocknet und anschließend 5 minuten in einer 1 %igen wäßrigen Dimethylaminboranlösung vorreduziert und gemäß Beispiel 3 verkupfert. Man erhält eine zusämmenhängende Kupferschicht.

Beispiel 5

Analog Beispiel 1 wird eine 40 %ige Lösung in PMA eines Copolymeren hergestellt, bestehend aus

```
        15 Gew.-Teilen  Styrol

        20 "                    Methylmethacrylat

        20 "                    n-Butylacrylat

        25 "                    Acrylnitril

        20 "                    α-Cyanacrylsäurebutylester.


       180 Gew.-Teile dieser Lösung werden gemäß Beispiel
                                10
  mit    90 Gew.-Teilen Ethylenglykolmethyletheracetat
          2 "                    Butadienpalladiumdichlorid
  und    17 "            Aerosil
```

vermischt.

Die dabei entstehende Druckpaste wird gemäß Beispiel 2 auf eine PES-Folie gedruckt, getrocknet und metallisiert. Man erhält eine vernickelte Folie. Haftfestigkeit nach DIN 53 151: Kennwert GT 1.

**Patentansprüche**

1. Verfahren zur Verbesserung der Haftfestigkeit von stromlos abgeschiedenen Metallschichten auf elektrisch nicht leitenden Substraten durch Behandlung derselben mit bindemittelhaltigen Aktivatorformulierungen ohne Beizen, wobei die Schritte
   (1) Aufbringung der bindemittelhaltigen Aktivatorformulierungen,
   (2) Entfernung der Lösungsmittel falls vorhanden,
   (3) Aktivierung durch Reduktion und
   (4) stromlose Metallisierung
   durchlaufen werden, dadurch gekennzeichnet, daß man als Bindemittel ein Copolymerisat aus
   a) 5 bis 80 Gew.-% eines cyangruppenhaltigen Monomeren aus der Gruppe von α-Cyanacrylsäureester mit 1 bis 8 C-Atomen im Alkoholrest, Maleinsäuredinitril, Fumarsäuredinitril, Acrylnitril und α-Alkylacrylnitrile,
   b) 5 bis 40 Gew.-% gegebenenfalls kernsubstituiertem (Methyl)Styrol aus der Gruppe von Styrol, α-Methylstyrol, o-Chlorstyrol, p-Chlorstyrol, o-, m- oder p-Methylstyrol, p-tert.-Butylstyrol und Methylmethacrylat oder deren Mischungen und/oder
   c) 5 bis 40 Gew.-% (Meth)Acrylsäureester aus der Gruppe der Acrylsäurealkylester mit 1 bis 18 C-Atomen im Alkoholteil und Methacrylsäurealkylester mit 2 bis 18 C-Atomen im Alkoholteil oder deren Mischungen und/oder
   d) 5 bis 40 Gew.-% ungesättigte Carbonsäure(derivate) aus der Gruppe der $\beta$-monoolefinisch ungesättigten Mono- oder Dicarbonsäuren mit 3 bis 5 C-Atomen und Maleinsäurehalbester mit 2 bis 18 C-Atomen im Alkoholteil oder deren Mischungen
   verwendet, das ein mittleres Molekulargewicht von 1.000 bis 1.000.000 aufweist.

2. Verfahren nach Anspruch 1, dadurch gekennzeichnet, daß man als Aktivatoren organische Metallverbindungen der 1. oder 8. Nebengruppe verwendet.

3. Verfahren nach Anspruch 1, dadurch gekennzeichnet, daß man als Bindemittel Copolymere mit einem Gehalt an Cyanmonomeren von 20 bis 50 Gew.-% verwendet.

6

**4.** Verfahren nach Anspruch 1, dadurch gekennzeichnet, daß die Formulierungen neben den Bindemitteln organische Metallverbindungen als Aktivatoren sowie Füllstoffe und organische Lösungsmittel enthalten,

**5.** Verwendung von Formulierungen gemäß Anspruch 1 als Druckpasten zur Herstellung von gedruckten Schaltungen, Folientastaturen, Schaltmatten und Sensoren.

**Claims**

**1.** Method for improving the bond strength of electrolessly deposited metal layers on electrically non-conducting substrates by treatment of the latter with binder-containing activator formulations without pickling, in which process the steps
(1) application of binder-containing activator formulations,
(2) removal of the solvent, if present,
(3) activation by reduction and
(4) electroless metallisation
are traversed, characterised in that a copolymer having a mean molecular weight of 1,000 to 1,000,000 and composed of
a) 5 to 80% by weight of a monomer containing cyano groups from the group comprising $\alpha$-cyanoacrylates having 1 to 8 carbon atoms in the alcohol radical, maleic dinitrile, fumaric dinitrile, acrylic dinitrile and $\alpha$-alkylacrylic nitriles,
b) 5 to 40% by weight of an optionally ring-substituted (methyl)styrene from the group comprising styrene, $\alpha$-methylstyrene, o-chlorostyrene, p-chlorostyrene, o-, m- or p-methylstyrene, p-tert-butylstyrene and methyl methacrylate or mixtures thereof and/or
c) 5 to 40% by weight of (meth)acrylates from the group comprising alkyl acrylates having 1 to 18 carbon atoms in the alcohol part and alkyl methacrylates having 2 to 18 carbon atoms in the alcohol part or mixtures thereof and/or
d) 5 to 40% by weight of unsaturated carboxylic acid (derivates) from the group comprising $\beta$-monoolefinically unsaturated mono- or dicarboxylic acids having 3 to 5 carbon atoms and maleic acid half-esters having 2 to 18 carbon atoms in the alcohol part or mixtures thereof
are used.

**2.** Method according to Claim 1, characterised in that organometallic compounds of the 1st or 8th subgroup are used as activators.

**3.** Method according to Claim 1, characterized in that copolymers with a cyano monomer content of 20 to 50% by weight are used as binder.

**4.** Method according to Claim 1, characterized in that, in addition to the binders, the formulations contain organometallic compounds as activators and also fillers and organic solvents.

**5.** Use of formulations according to Claim 1 as printing pastes for producing printed circuits, membrane keyboards, switching mats and sensors.

**Revendications**

**1.** Procédé pour améliorer l'adhérence de couches métalliques déposées par voie chimique sur des substrats ne conduisant pas l'électricité, par traitement de ces derniers avec des formulations d'activateur contenant un liant, sans décapage, avec exécution des opérations suivantes :
(1) application des formulations d'activateur contenant un liant,
(2) élimination des solvants, s'ils sont présents,
(3) activation par réduction et
(4) métallisation par voie chimique,
caractérisé en ce qu'on utilise comme liant un produit de copolymérisation
a) de 5 à 80 % en poids d'un monomère porteur de groupes cyano choisi dans le groupe comprenant des esters d'acide $\alpha$-cyanacrylique ayant 1 à 8 atomes de carbone dans le reste alcool, le dinitrile d'acide maléique, le dinitrile d'acide fumarique, l'acrylonitrile et des $\alpha$-alkylacrylonitriles,
b) 5 à 40 % en poids de (méthyl)styrène éventuellement substitué sur le noyau, du groupe comprenant le styrène, l'$\alpha$-méthylstyrène, le o-chlorostyrène, le p-chlorostyrène, le o-, le m- ou le p-méthylstyrène, le p-tertio-butylstyrène et le méthacrylate de méthyle ou leurs mélanges et/ou

c) 5 à 40 % en poids d'ester d'acide (méth)acrylique du groupe d'esters alkyliques d'acide acrylique ayant 1 à 18 atomes de carbone dans la partie alcool et des esters alkyliques d'acide méthacrylique ayant 2 à 18 atomes de carbone dans la partie alcool ou leurs mélanges, et/ou

d) 5 à 40 % en poids d'acides carboxyliques non saturés (ou leurs dérivés) du groupe des acides monocarboxyliques ou dicarboxyliques à nonsaturation $\beta$-mono-oléfinique ayant 3 à 5 atomes de carbone et des demi-esters d'acide maléique ayant 2 à 18 atomes de carbone dans la partie alcool, ou leurs mélanges,

ce produit présentant un poids moléculaire moyen de 1000 à 1 000 000.

2. Procédé suivant la revendication 1, caractérisé en ce qu'on utilise comme activateurs des composés organométalliques du premier ou du huitième sous-groupe.

3. Procédé suivant la revendication 1, caractérisé en ce qu'on utilise comme liant des copolymères ayant une teneur en monomères à groupes cyano de 20 à 50 % en poids.

4. Procédé suivant la revendication 1, caractérisé en ce que les formulations contiennent, à côté des liants, des composés organométalliques comme activateurs de même que des charges et des solvants organiques.

5. Utilisation de formulations suivant la revendication 1 comme pâtes d'impression pour la réalisation de circuits imprimés, de claviers à effleurement, de nattes de contact et de palpeurs.